# EUROPEAN PATENT APPLICATION

(11) **EP 3 778 823 A1**
(43) Date of publication of application: **17.02.2021**
(21) Application number: 19775427.8
(22) Date of filing: 14.03.2019
(51) Int. Cl.: C09K 3/14, B24B 37/00, H01L 21/304

(54) **POLISHING COMPOSITION**

(30) Priority: 28.03.2018 JP 2018061561
(71) Applicant: Fujimi Incorporated, Kiyosu-shi, Aichi 452-8502 (JP)
(72) Inventor: KON, Hiroki, Kiyosu-shi, Aichi 452-8502 (JP)
(74) Representative: Grünecker Patent- und Rechtsanwälte PartG mbB
(86) International application number: PCT/JP2019/010632
(87) International publication number: WO 2019/188359

(57) **Abstract**

The present invention provides a means capable of polishing an object to be polished at a high polishing removal rate and further improving a surface quality of a surface of the object to be polished.

The present invention is a polishing composition used for polishing an object to be polished, containing an alumina abrasive and a dispersion medium, in which the alumina abrasive contain only an α-alumina A having an α conversion rate of 80% or more and an α-alumina B having an α conversion rate of less than 80% as crystalline alumina, and an average particle size of the α-alumina A is smaller than an average particle size of the α-alumina B.

## Description

### TECHNICAL FIELD

The present invention relates to a polishing composition.

### BACKGROUND ART

As materials of substrates for optical devices and materials of substrates for power devices, hard and brittle materials such as aluminum oxide (for example, sapphire), zirconium oxide, aluminum nitride, silicon nitride, gallium nitride, and silicon carbide are known. Substrates or films formed of these hard and brittle materials are generally stable to chemical actions such as oxidation, complexation, and etching, and therefore cannot be easily processed by polishing. For this reason, such substrates are generally processed by grinding or cutting using hard materials. However, there is a problem that the polishing removal rate becomes low.

Against such a problem, International Publication No. 2012/115020 (corresponding to U.S. Patent Application Publication No. 2013/0324015) discloses a polishing composition used for polishing a hard and brittle material having a Vickers hardness of 1,500 Hv or higher, containing at least an aluminum oxide abrasive and water, in which the polishing composition has a pH of 8.5 or higher, and in which the aluminum oxide abrasive have a specific surface area of 20 m²/g or less. International Publication No. 2012/115020 (corresponding to U.S. Patent Application Publication No. 2013/0324015) describes that by using a polishing composition having such a configuration, an object to be polished containing a hard and brittle material can be polished at a high polishing removal rate.

In addition, JP 2015-120816 A and JP 2011-121151 A disclose a polishing liquid composition in which a magnetic disk substrate is used as an object to be polished, and an α-alumina having different α conversion rate are mixed and used. These techniques describe that a high polishing removal rate can be obtained, and defects on a surface of the object to be polished can be reduced.

### SUMMARY OF INVENTION

However, in the technique described in International Publication No. 2012/115020 (corresponding to U.S. Patent Application Publication No. 2013/0324015), although the polishing removal rate is high, there is room for improvement in a surface quality of the surface of the object to be polished. In addition, the techniques described in JP 2015-120816 A and JP 2011-121151 A are not suitable for an object to be polished containing a hard and brittle material, and there is room for improvement in the polishing removal rate and the surface quality of the surface of the object to be polished.

Thus, an object of the present invention is to provide a means capable of polishing an object to be polished at a high polishing removal rate and further improving a surface quality of a surface of the object to be polished.

In order to solve the above problems, the present inventor conducted intensive studies. As a result, the present inventors have found that the above problems can be solved by a polishing composition containing only an α-alumina A having an α conversion rate of 80% or more and an α-alumina B having an α conversion rate of less than 80% as crystalline alumina and containing an alumina abrasive in which an average particle size of the α-alumina A is smaller than an average particle size of the α-alumina B. Based on the above finding, the present invention is completed accordingly.

That is, the present invention is a polishing composition used for polishing an object to be polished, containing an alumina abrasive and a dispersion medium, in which the alumina abrasive contain only an α-alumina A having an α conversion rate of 80% or more and an α-alumina B having an α conversion rate of less than 80% as crystalline alumina, and an average particle size of the α-alumina A is smaller than an average particle size of the α-alumina B.

### DESCRIPTION OF EMBODIMENTS

The present invention is a polishing composition used for polishing an object to be polished, containing an alumina abrasive and a dispersion medium, in which the alumina abrasive contain only an α-alumina A having an α conversion rate of 80% or more and an α-alumina B having an α conversion rate of less than 80% as crystalline alumina, and an average particle size of the α-alumina A is smaller than an average particle size of the α-alumina B. By using the polishing composition of the present invention having such a configuration, the object to be polished can be polished at a high polishing removal rate, and a surface quality of a surface of the object to be polished can be further improved.

The reason why the above-mentioned effects are obtained by the polishing composition of the present invention is not clarified in detail, but the reason is estimated as follows.

Since an α-alumina having a moderately low α conversion rate also contains components such as amorphous alumina having low hardness, catching on an object to be polished and the like are likely to occur. Although the α-alumina provides the effect of improving the polishing removal rate, dents and scratches are likely to occur, and the surface quality of a surface of the object to be polished tends to deteriorate. On the other hand, in an α-alumina having a high α conversion rate when the particle size is approximately the same, catching on an object to be polished and the like are less likely to occur, and as compared with an α-alumina having a low α conversion rate, dents and scratches are reduced to improve the surface quality of the surface of the object to be polished; however, it tends to be difficult to obtain the effect of improving the polishing removal rate.

On the other hand, the polishing composition of the present invention uses in combination an α-alumina A having a small diameter and having an α conversion rate of 80% or more, and an α-alumina B having a larger diameter than the α-alumina A and having an α conversion rate of less than 80%. Due to such a combined use, the α-alumina A having a small diameter and high hardness is present during polishing with the α-alumina B, so that it is considered that the α-alumina A plays the role of a buffer or the like in a contact between the α-alumina B and the object to be polished. Thus, it is considered that catching of the α-alumina B, having a low α conversion rate, on the object to be polished is reduced, dents, scratches, and the like are reduced while maintaining a high polishing removal rate, and the effect of improving the surface quality of the surface of the object to be polished can be obtained. In addition, it is further considered that even if scratches and the like occur, the α-alumina A having high hardness further polishes the surface of the object to be polished to further reduce the scratches.

Note that, the above mechanism is based on a presumption, and the present invention is not limited to the above mechanism at all.

### [Object to be polished]

Examples of the object to be polished include, but are not particularly limited to, metals, semiconductors, glass, ceramics, and the like.

According to a preferred embodiment of the present invention, the object to be polished includes a hard and brittle material. Examples of hard and brittle materials include glass, ceramics, stone materials, and various semiconductor materials, for example. More specific examples include diamond, sapphire (aluminum oxide), zirconium oxide, silicon carbide, boron carbide, zirconium carbide, tungsten carbide, silicon nitride, titanium nitride, gallium nitride, aluminum nitride, and the like.

According to another preferred embodiment of the present invention, the object to be polished includes a hard and brittle material having a Vickers hardness of 1500 Hv or higher. Examples of such a hard and brittle material having a Vickers hardness of 1500 Hv or higher include sapphire, silicon carbide, gallium nitride, and the like.

The hard and brittle materials may be used alone or in combination of two or more thereof.

Among these materials, the object to be polished preferably contains at least one hard and brittle material selected from the group consisting of sapphire, silicon carbide, and gallium nitride, more preferably contains at least one hard and brittle material selected from the group consisting of silicon carbide and gallium nitride, and still more preferably contains silicon carbide. Silicon carbide is expected as a semiconductor substrate material having low power losses and excellent heat resistance and the like, and the practical advantage of improving surface properties thereof is particularly great.

Next, a configuration of the polishing composition of the present invention will be described in detail.

### [Alumina abrasive]

The polishing composition of the present invention contains an alumina abrasive s.

The alumina abrasive contain only the α-alumina A having an α conversion rate of 80% or more and the α-alumina B having an α conversion rate of less than 80% as crystalline alumina. As crystalline alumina particles, in addition to the α-alumina, alumina particles called intermediate alumina such as γ-alumina, δ-alumina, θ-alumina, η-alumina, κ-alumina, and χ-alumina are known. However, the alumina abrasive according to the present invention contain only the α-alumina A having an α conversion rate of 80% or more and the α-alumina B having an α conversion rate of less than 80% as crystalline alumina and contain no intermediate alumina. The fact that the alumina abrasive used in the present invention contain no intermediate alumina can be confirmed by the fact that no peak derived from the intermediate alumina is detected in a diffraction peak obtained by performing X-ray diffraction measurement on the alumina abrasive.

Note that, the alumina abrasive may contain amorphous alumina as long as the effects of the present invention are not impaired.

The α conversion rate of the α-alumina A is 80% or more, and from the viewpoint of improving the polishing removal rate and the surface quality, the α conversion rate is preferably 82% or more, and more preferably 85% or more. The upper limit value of the α conversion rate of the α-alumina A is preferably 100% or less, and more preferably 95% or less. Note that, if the α conversion rate is within the above range, plural kinds of α-alumina A may be used.

In addition, the α conversion rate of the α-alumina B is less than 80%, and from the viewpoint of improving the polishing removal rate and the surface quality, the α conversion rate is preferably 79% or less, and more preferably 78% or less. In addition, the lower limit value of the α conversion rate of the α-alumina B is preferably 60% or more, and more preferably 70% or more. Note that, if the α conversion rate is within the above range, plural kinds of α-alumina B may be used.

In the present description, as the α conversion rate, a value obtained from integrated intensity of a diffraction line peak (2θ = 57.5°) peculiar to the α-alumina in an X-ray diffraction spectrum is adopted. More specifically, the α conversion rate can be determined by the method described in Examples.

In the present invention, the average particle size of the α-alumina A is smaller than the average particle size of the α-alumina B. When the average particle size of the α-alumina A is equal to or larger than the average particle size of the α-alumina B, although a tendency of improvement in the polishing removal rate is observed, dents and scratches derived from the α-alumina A tend to increase. In a preferred embodiment, the average particle size of the α-alumina A is preferably smaller than 0.9 times, more preferably smaller than 0.8 times, and still more preferably 0.75 times or less, relative to the average particle size of the α-alumina B.

In another preferred embodiment of the present invention, the average particle size of the α-alumina A is preferably less than 0.4 µm, more preferably 0.35 µm or less, and still more preferably 0.32 µm or less. In addition, the lower limit value of the average particle size of the α-alumina A is preferably 0.1 µm or more, and more preferably 0.2 µm or more.

In a preferred embodiment of the present invention, the average particle size of the α-alumina B is preferably 0.4 µm or more, more preferably 0.41 µm or more, and still more preferably 0.43 µm or more. In addition, the upper limit value of the average particle size of the α-alumina B is preferably 5 µm or less, and more preferably 2.5 µm or less.

In the present description, as the average particle sizes of the α-alumina A and the α-alumina B, a volume-based median diameter (D50) (volume average particle size) measured by a laser diffraction scattering method is adopted. More specifically, the average particle size can be measured using a laser diffraction/scattering type particle size distribution measuring device (product name "LA-950") manufactured by Horiba, Ltd.

In a preferred embodiment of the present invention, the crystallite size of at least one of the α-alumina A and the α-alumina B is preferably more than 42 nm, and more preferably 45 nm or more. In another preferred embodiment of the present invention, a crystallite size of the α-alumina A is preferably 40 nm or less, more preferably 38 nm or less, and still more preferably 35 nm or less. In another preferred embodiment of the present invention, the crystallite size of the α-alumina B is preferably 45 nm or more, more preferably 50 nm or more, and still more preferably 60 nm or more.

Note that, the crystallite of the α-alumina refers to a single crystal that constitutes secondary particles of the α-alumina. The crystallite size can be calculated by Scherrer's formula based on data obtained from the X-ray diffraction spectrum, and more specifically, can be determined by the method described in Examples.

The content of the alumina abrasive in the polishing composition (that is, a total content of the α-alumina A and the α-alumina B) is not particularly limited, and from the viewpoint of shortening processing time, the content of the alumina abrasive is preferably 0.1% by mass or more, more preferably 0.5% by mass or more, still more preferably 1% by mass or more, and particularly preferably 3% by mass or more. From the viewpoint of polishing stability, cost reduction, etc., the content of the alumina abrasive is appropriately 20% by mass or less, preferably 15% by mass or less, more preferably 12% by mass or less, and still more preferably 10% by mass or less. The technique disclosed herein can be preferably implemented, for example, in an aspect wherein the content of the alumina abrasive in the polishing composition is 0.1% by mass or more and 20% by mass or less (preferably 3% by mass or more and 10% by mass or less).

A content mass ratio of the α-alumina A and the α-alumina B (a-alumina A/α-alumina B) is not particularly limited, but is preferably 5/95 or more and 95/5 or less. In a preferred embodiment of the present invention, from the viewpoint of obtaining a higher polishing removal rate, the content mass ratio of the α-alumina A and the α-alumina B (a-alumina A/α-alumina B) is more preferably 7/93 or more and 30/70 or less, and still more preferably 10/90 or more and 20/80 or less. In another preferred embodiment of the present invention, from the viewpoint of improving the surface quality of the object to be polished, the content mass ratio of the α-alumina A and the α-alumina B (a-alumina A/α-alumina B) is more preferably 70/30 or more and 93/7 or less, and still more preferably 80/20 or more and 90/10 or less.

As the α-alumina A and the α-alumina B, a commercially available product may be used, or a synthesized product may be used. A production method (synthesis method) of the α-alumina A and the α-alumina B is not particularly limited, and the α-alumina A and the α-alumina B can be produced by appropriately referring to a general production method of the α-alumina. The α conversion rates of the α-alumina A and the α-alumina B can be controlled by, for example, the firing temperature, firing time and the like during production. Generally, the higher the firing temperature and the longer the firing time, the higher the α conversion rate. Furthermore, the average particle sizes of the α-alumina A and the α-alumina B can be controlled by, for example, conditions during pulverization of a raw powder or the like.

### <Abrasive other than alumina abrasive >

The polishing composition of the present invention may contain an abrasive (hereinafter, also referred to as a non-alumina abrasive) made of a material other than the above-mentioned alumina abrasive as long as the effect of the present invention is not impaired. Examples of such non-alumina abrasives include an abrasive essentially formed of any one species among oxide particles such as silica particles (silicon oxide particles), cerium oxide particles, chromium oxide particles, titanium oxide particles, zirconium oxide particles, magnesium oxide particles, manganese oxide particles, zinc oxide particles, and iron oxide particles; nitride particles such as silicon nitride particles and boron nitride particles; carbide particles such as silicon carbide particles and boron carbide particles; diamond particles; carbonates such as calcium carbonate and barium carbonate; and the like.

In a preferred embodiment of the present invention, a content ratio of the above-mentioned non-alumina abrasive is preferably 20% by mass or less, more preferably 10% by mass or less, still more preferably 5% by mass or less, and particularly preferably 0% by mass of the whole mass of the abrasive contained in the polishing composition, and, that is, it is particularly preferred that no non-alumina abrasive is contained.

In a preferred embodiment of the present invention, a content ratio of the alumina abrasive is preferably 80% by mass or more, more preferably 90% by mass or more, still more preferably 95% by mass or more, and particularly preferably 100% by mass of the whole mass of the abrasives contained in the polishing composition.

### [Dispersion medium]

The dispersion medium used in the polishing composition of the present invention is not particularly limited as long as it can disperse the alumina abrasive. Water can be preferably used as the dispersion medium. From the viewpoint of suppressing inhibiting the activity of other components, water that does not contain impurities as far as possible is preferred, and specifically, it is more preferable to use ion-exchanged water (deionized water), pure water, ultrapure water, distilled water and the like. The dispersion medium may further contain, as necessary, an organic solvent able to uniformly mix with water, such as lower alcohol or lower ketone. In usual, preferably 90% by volume or more of the dispersion medium contained in the polishing composition is water, or more preferably 95% by volume or more (typically 99% by volume or more) is water.

### [pH]

According to a preferred embodiment of the present invention, the lower limit of pH of the polishing composition is preferably 1 or more, more preferably 3 or more, still more preferably 5 or more, and particularly preferably 7 or more.

In addition, according to a preferred embodiment of the present invention, the upper limit of the pH of the polishing composition is preferably 12 or less, more preferably 11 or less, and still more preferably 10 or less.

According to another preferred embodiment of the present invention, the pH of the polishing composition is preferably 7 or more, more preferably 8 or more, and still more preferably 8.5 or more, and preferably 12 or less, more preferably 11 or less, and still more preferably 10 or less. Within such a range, the effects of the present invention can be better exhibited.

A pH adjusting agent may be used to adjust the pH to the desired pH. As for the pH adjusting agent, any of known acid, base, or a salt thereof can be used. The pH adjusting agent can be used either singly or in combination of two or more types. In addition, the addition amount of the pH adjusting agent is not particularly limited, and the addition amount may be appropriately adjusted so that the polishing composition can have a desired pH.

Note that, as the pH, a value measured by the method described in Examples is adopted.

### [Oxidizing agent]

The polishing composition of the present invention preferably contains an oxidizing agent. The oxidizing agent is a component that enhances the effect of polishing, and a water-soluble oxidizing agent is typically used. Although the oxidizing agent is not particularly limitedly interpreted, it is considered that the oxidizing agent exhibits an effect of oxidatively deteriorating the surface of the object to be polished in polishing and brings about weakening of the surface of the object to be polished, thereby contributing to polishing by an abrasive.

Examples of the oxidizing agent include peroxides such as hydrogen peroxide; nitric acid compounds such as nitric acid, as well as iron nitrate, silver nitrate, and aluminum nitrate which are salts thereof and ceric ammonium nitrate which is a complex thereof; persulfuric acid compounds such as persulfuric acids including potassium peroxymonosulfate, peroxodisulfuric acid, and the like, as well as ammonium persulfate and potassium persulfate which are salts thereof; chlorine compounds such as chloric acid, as well as salts thereof, and perchloric acid, as well as potassium perchlorate which is a salt thereof; bromine compounds such as bromic acid, as well as potassium bromate which is a salt thereof; iodine compounds such as iodic acid, as well as ammonium iodate which is a salt thereof, and periodic acid, as well as sodium periodate and potassium periodate which are salts thereof; ferric acids such as ferric acid, as well as potassium ferrate which is a salt thereof; permanganic acids such as permanganic acid, as well as sodium permanganate and potassium permanganate which are salts thereof; chromic acids such as chromic acid, as well as potassium chromate and potassium dichromate which are salts thereof; vanadic acids such as vanadic acid, as well as ammonium vanadate, sodium vanadate, and potassium vanadate which are salts thereof; ruthenium acids such as perruthenium acid and salts thereof; molybdic acids such as molybdic acid, as well as ammonium molybdate and disodium molybdate which are salts thereof; rhenic acids such as perrhenium and salts thereof; tungstic acids such as tungstic acid, as well as disodium tungstate which is a salt thereof; and the like.

These oxidizing agents may be used either singly or in appropriate combination of two or more types. Among them, from the viewpoint of polishing removal rate and the like, permanganic acid or a salt thereof, peroxide, vanadic acid or a salt thereof, and periodic acid or a salt thereof are preferable, and sodium permanganate and potassium permanganate are more preferable.

In a preferred embodiment, the polishing composition contains a composite metal oxide as an oxidizing agent. Examples of the composite metal oxide include metal nitrates, ferric acids, permanganic acids, chromic acids, vanadic acids, ruthenic acids, molybdic acids, rhenium acids, tungstic acids, and the like. Among them, ferric acids, permanganic acids, and chromic acids are more preferable, and permanganic acids are even more preferable.

In a more preferred embodiment, a composite metal oxide CMO including a monovalent or divalent metal element (provided that transition metal elements are excluded) and a transition metal element in the fourth period in the periodic table is used as the composite metal oxide. Preferred examples of the monovalent or divalent metal element (provided that transition metal elements are excluded) include Na, K, Mg, and Ca. Among them, Na and K are more preferable. Preferred examples of the transition metal element in the fourth period in the periodic table include Fe, Mn, Cr, V, Ti, and the like. Among them, Fe, Mn, and Cr are more preferable, and Mn is even more preferable.

When the polishing composition of the present invention contains a composite metal oxide (preferably the composite metal oxide CMO) as an oxidizing agent, the polishing composition may or need not further contain an oxidizing agent other than the composite metal oxide. The technique disclosed herein can be preferably carried out even in an aspect in which an oxidizing agent (for example, hydrogen peroxide) other than the composite metal oxide (preferably the composite metal oxide CMO) is not substantially contained as the oxidizing agent.

A content (concentration) of the oxidizing agent in the polishing composition is preferably 0.1% by mass or more. From the viewpoint of simultaneously realizing the polishing removal rate and the surface quality at a high level and efficiently, the content of the oxidizing agent is more preferably 0.3% by mass or more, still more preferably 0.5% by mass or more, and particularly preferably 0.8% by mass or more. In addition, from the viewpoint of improving smoothness, the content of the oxidizing agent is preferably 10% by mass or less, more preferably 8% by mass or less, still more preferably 6% by mass or less, even more preferably 5% by mass or less, and particularly preferably 3% by mass or less.

### [Other components]

As long as the effects of the present invention are not impaired, the polishing composition of the present invention may further contain, as necessary, known additives that can be used for a polishing composition (typically, a composition for polishing a material with a high hardness, for example, a composition for polishing a silicon carbide substrate) such as a chelating agent, a thickener, a dispersant, a surface protective agent, a wetting agent, a surfactant, an organic acid, an organic acid salt, an inorganic acid, an inorganic acid salt, a corrosion inhibitor, an antiseptic agent, and an antifungal agent. The content of the above additive may be appropriately set according to the purpose of addition thereof.

### [Method of producing polishing composition]

The method of producing the polishing composition is not particularly limited, but preferably include mixing the α-alumina A having an α conversion rate of 80% or more and the α-alumina B having an α conversion rate of less than 80% with other components optionally contained in the dispersion medium. That is, the present invention provides a method of producing a polishing composition, including mixing the α-alumina A having an α conversion rate of 80% or more and the α-alumina B having an α conversion rate of less than 80% in a dispersion medium, in which the average particle size of the α-alumina A is smaller than the average particle size of the α-alumina B.

A method of mixing the α-alumina A, the α-alumina B, and other components optionally contained is not particularly limited, and, for example, the respective components may be mixed using a known mixing device such as a blade type stirrer, an ultrasonic disperser, or a homomixer. An aspect in which these components are mixed is not particularly limited, and, for example, all components may be mixed at once or may be mixed according to an appropriately set order.

When each component is mixed, the temperature is not particularly limited, and is preferably 10°C or higher and 40°C or lower, and heating may be performed to increase a rate of dissolution. The mixing time is also not particularly limited.

The polishing composition of the present invention may be a one-agent type or a multi-agent type including a two-agent type. For example, the polishing composition may be configured in such a manner that a liquid A containing some of the components (typically, components other than the dispersion medium) of the polishing composition is mixed with a liquid B containing the remaining components, and the mixture is used for polishing an object to be polished.

### <Concentrate>

The polishing composition may be in a concentrated form (i.e. in a form of a concentrate of a polishing liquid) before supplied to an object to be polished. The polishing composition in a concentrated form as this is advantageous from the viewpoint of the convenience, cost reduction and the like for production, distribution, storage, etc. The concentration factor can be, for example, about 2 times to 5 times by volume.

The polishing composition in a concentrate form as this can be used in an aspect where it is diluted whenever desired to prepare a polishing liquid and the polishing liquid is supplied to an object to be polished. The dilution can be carried out typically by adding and mixing an above-mentioned dispersion medium with the concentrate. In addition, when the dispersion medium is a mixture, the dilution may be performed by adding just some of the components of the dispersion medium or by adding a mixed dispersion medium containing the components at a mass ratio different from that of the dispersion medium. In addition, with respect to a multi-agent type polishing composition as described later, some of the components may be diluted first and then mixed with other components to prepare a polishing liquid, or the multiple components may be mixed first followed by dilution of the mixture to prepare a polishing liquid.

The content of abrasives in the concentrate is preferably 40% by mass or less. From the viewpoint of the stability (for example, dispersion stability of abrasive) and filterability of the polishing composition, etc., the content of abrasives is more preferably 30% by mass or less, still more preferably 20% by mass or less, and particularly preferably 15% by mass or less. In addition, from the viewpoint of the convenience, cost reduction and the like for production, distribution, storage, etc., the content of abrasives in the concentrate is preferably 0.2% by mass or more, more preferably 1% by mass or more, still more preferably 5% by mass or more, and particularly preferably 10% by mass or more.

### [Polishing method]

The polishing composition of the present invention can be used for polishing an object to be polished, for instance, in an aspect including the following operations.

That is, a polishing liquid (slurry) containing any of the polishing compositions disclosed here is prepared. The preparing a polishing liquid can include preparing a polishing liquid by subjecting a polishing composition to operations such as concentration adjustment (for example, dilution) and pH adjustment. Alternatively, the polishing composition may be used, as it is, as the polishing liquid. In addition, for a multi-agent type polishing composition, the preparing a polishing liquid can include mixing agents, diluting one or a plurality of agents before the mixing, diluting the mixture after the mixing, and the like.

Next, the polishing liquid is supplied to a surface of an object to be polished, and the object is polished in general ways. For example, an object to be polished is set to a common polishing machine, and the polishing liquid is supplied to a surface (surface to be polished) of the object to be polished through a polishing pad of the polishing machine. Typically, while the polishing liquid is continuously supplied, the polishing pad is pressed against the surface of the object to be polished, and the polishing pad and the object to be polished are relatively moved (for example, rotationally moved). Through the polishing step, the polishing of the object to be polished is completed.

According to one embodiment of the present invention, there are provided a polishing method for polishing an object to be polished containing a hard and brittle material, and a method of producing a polished object to be polished using the polishing method. The above polishing method is characterized by including a step of polishing an object to be polished using the polishing composition disclosed herein. The polishing method according to a preferred embodiment includes a step of performing preliminary polishing (preliminary polishing step) and a step of performing final polishing (final polishing step). The preliminary polishing step here refers to a step of performing preliminary polishing on an object to be polished. In a typical aspect, the preliminary polishing step is a polishing step set immediately before the final polishing step. The preliminary polishing step may be a single-step of polishing or a polishing step of a plurality of steps of two or more. In addition, the final polishing step herein refers to a step of performing final polishing on an object to be polished on which preliminary polishing is performed and is a polishing step provided at the end (that is, on the most downstream side) among polishing steps performed using a polishing slurry containing an abrasive. In such a polishing method including a preliminary polishing step and a final polishing step, the polishing composition disclosed here may be used in the preliminary polishing step or may be in the final polishing step, or in both the preliminary polishing step and the final polishing step.

In a preferred embodiment, the polishing step using the above-mentioned polishing composition may be a preliminary polishing step. The polishing composition disclosed here is suitable as a polishing composition (composition for preliminary polishing) used for the preliminary polishing step performed on the surface of the object to be polished since a high polishing removal rate can be achieved. When the preliminary polishing step includes a polishing step of a plurality of steps of two or more, a polishing step in two or more steps among these steps can also be performed using any of the polishing compositions disclosed here. The polishing composition disclosed here can be preferably applied for preliminary polishing at a former step (upstream). For example, the polishing composition can also be preferably used in an initial preliminary polishing step (typically, the first polishing step) after a lapping step to be described below.

In another preferred embodiment, the polishing step using the above-mentioned polishing composition is the final polishing step. The polishing composition disclosed here can effectively reduce the number of scratches on the surface after polishing, and thus can be particularly preferably used as a polishing composition (composition for final polishing) used in the final polishing step performed on the surface of the object to be polished.

The preliminary polishing step and the final polishing step can be applied to both polishing using a single-side polishing machine and polishing using a double-side polishing machine. In the single-side polishing machine, an object to be polished is adhered to a ceramic plate with wax, the object to be polished is held using a holder called a carrier, and while a polishing composition is supplied, a polishing pad is pressed against one side of the object to be polished, they are moved relative to each other (for example, rotationally moved), and thus one side of the object to be polished is polished. In the double-side polishing machine, an object to be polished is held using a holder called a carrier, and while a polishing composition is supplied from above, each polishing pad is pressed against each side faced to the object to be polished, these are rotated in a relative direction, and thus both sides of the object to be polished are polished at the same time.

The polishing pad used in each polishing step is not particularly limited. For example, any polishing pad of a non-woven fabric type, a suede type, a hard foamed polyurethane type, a type containing an abrasive, a type containing no abrasive, and the like may be used.

The polished object to be polished, which has been polished by the above-mentioned polishing method, is typically cleaned after polishing. This cleaning can be performed using an appropriate cleaning solution. A cleaning solution to be used is not particularly limited, and known or conventional ones can be appropriately selected and used.

Note that, the polishing method may include any other step in addition to the preliminary polishing step and the final polishing step. Examples of such a process include a lapping process performed before the preliminary polishing step. The lapping step is a step of polishing an object to be polished by pressing a surface of a polishing table (for example, a cast iron platen) against the object to be polished. Therefore, in the lapping step, no polishing pad is used. The lapping step is typically performed by supplying an abrasive (typically, a diamond abrasive) between the polishing table and the object to be polished. In addition, the polishing method disclosed here may include additional steps (a cleaning step or a polishing step) before the preliminary polishing step or between the preliminary polishing step and the final polishing step.

The present invention may include a method of producing a polished object to be polished including a polishing step using the above-mentioned polishing composition (for example, a method of producing a silicon carbide substrate) and a polished object to be polished produced by the method. That is, according to the present invention, provided is a method of producing a polished object to be polished including supplying any of the polishing compositions disclosed here to an object to be polished containing a hard and brittle material and polishing the object to be polished, and a polished object to be polished produced by the method. The production method can be performed by preferably applying details of any of the polishing methods disclosed here. By the production method, a polished object to be polished (for example, a silicon carbide substrate) having a polished surface with improved surface quality can be efficiently provided.

### Example

The present invention will be described in more detail with reference to the following Examples and Comparative Examples. However, the technical scope of the present invention is not limited to only the following Examples.

The volume average particle size (D50) of the alumina abrasive was measured by a laser diffraction/scattering particle size distribution measuring device (LA-950 manufactured by Horiba, Ltd.).

The α conversion rate and crystallite size of the alumina abrasive were determined by X-ray diffraction measurement under the following measurement conditions;
Apparatus: Powder X-ray diffractometer Ultima IV manufactured by Rigaku Corporation
X-ray generation voltage: 40 kV
Radiation: Cu-Kα1 ray
Current: 10 mA
Scan speed: 10°/min
Measurement step: 0.01°

The α conversion rate was calculated based on the integrated intensity of the diffraction line peak (2θ = 57.5°) peculiar to the α-alumina. In addition, the crystallite size was calculated using powder X-ray diffraction pattern integrated analysis software JADE (manufactured by MDI, automatic calculation by Scherrer's formula).

Three types of alumina particles shown in Table 1 below were prepared.

**[Table 1]**

| | Volume average particle size (µm) | α conversion rate (%) | Crystallite size (nm) |
|---|---|---|---|
| Alumina A1 | 0.31 | 88 | 34 |
| Alumina B1 | 0.44 | 76 | 72 |
| Alumina B2 | 2.37 | 76 | 74 |

Note that, no peak derived from crystalline alumina other than the α-alumina was confirmed in the above-mentioned three types of alumina particles.

### (Example 1)

The alumina A1 and the alumina B1 were provided as abrasive, and mixed in water so that alumina A1: alumina B1 = 1: 9 (mass ratio) and the content of the entire abrasives was 6% by mass. Next, potassium permanganate was added to a content of 2% by mass, followed by stirring at room temperature (25°C) for 30 minutes, thereby preparing a dispersion. While checking the pH of the dispersion with a pH meter (manufactured by Horiba, Ltd.), an aqueous potassium hydroxide solution (concentration 48% by mass) was added as alkali to the dispersion so that the content was 0.01% by mass, the pH was adjusted to 9.0, and the polishing composition was prepared.

### (Examples 2 to 5)

A polishing composition was prepared in the same manner as in Example 1 except that the alumina A1 and the alumina B1 were used such that the mass ratio of the alumina A1 and the alumina B1 was set to the mass ratio shown in Table 2 below.

### (Comparative Examples 1 to 4)

A polishing composition was prepared in the same manner as in Example 1 except that the alumina particles shown in Table 2 below were used instead of the alumina A1 and the alumina B1.

(Polishing removal rate and evaluation of surface quality)

### [Polishing removal rate]

Using each of the polishing compositions of Examples 1 to 5 and Comparative Examples 1 to 4, a silicon carbide substrate was polished under the following polishing conditions.

### <Silicon carbide substrate polishing conditions>

Silicon carbide (SiC) substrate: 2-inch, N type, 4H-SiC, 4° off
Polishing machine: EJ-3801N (manufactured by Engis Japan Corporation)
Polishing pad: Nonwoven pad SUBA800 (manufactured by Nitta Haas Incorporated)
Polishing load: 300 g/cm²
Rotational speed of polishing table: 80 rpm
Polishing time: 30 min

After polishing using the polishing composition of each Example and Comparative Example, the mass of the SiC substrate was measured, and a difference in mass before and after polishing was divided by the polishing time to calculate the polishing removal rate. Note that, the polishing removal rate in Table 2 shows the ratio when the polishing removal rate in a case of using the polishing composition of Comparative Example 1 was 100%.

### [Evaluation of surface quality (Ra, number of concave defects, and number of scratches)]

Surface roughness Ra of the surface of the object to be polished after polishing was measured using an atomic force microscope (AFM, manufactured by Park Systems, NX-HDM) at four points including the center per sheet in a measuring field of 10 µm □ (10 µm square), and an average value of three substrates was obtained. Note that, the surface roughness Ra is a parameter that indicates the average of amplitude in the height direction of a roughness curve, representing the arithmetic average of surface height of an object to be polished within a fixed visual field.

For AFM images obtained in the above measurement, the number of dent defects (dotted recesses) and the number of scratches were confirmed image by image with attached software and determined by totaling twelve images per example, and the dent defects and a depth of the scratch were also confirmed.

The evaluation results are shown in Table 2 below.

**[Table 2]**

| | Alumina abrasive grain (mass ratio) | Polishing rate (%, as compared with Comparative Example 1) | Ra (nm) | Number of dent defects (depth 0.3 nm or more) | Number of scratches |
|---|---|---|---|---|---|
| Example 1 | A1/B1 = 10/90 | 108.8 | 0.053 | 12 | (7)* |
| Example 2 | A1/B1 = 25/75 | 102.8 | 0.055 | 8 | (7)* |
| Example 3 | A1/B1 = 50/50 | 101.5 | 0.051 | 8 | (11)* |
| Example 4 | A1/B1 = 75/25 | 90.0 | 0.051 | 7 | (9)* |
| Example 5 | A1/B1 = 90/10 | 86.6 | 0.051 | 2 | 0 |
| Comparative Example 1 | only B1 | 100 | 0.057 | 56 | 12 |
| Comparative Example 2 | only B2 | 100.4 | 0.067 | >200 | 18 |
| Comparative Example 3 | only A1 | 63.3 | 0.049 | 14 | 0 |
| Comparative Example 4 | B1/B2 = 50/50 | 100.8 | 0.066 | >200 | 25 |

| | | | | | |
|---|---|---|---|---|---|
| *: Depth 0.2 mm or less | | | | | |

As is clear from Table 2 above, when the polishing composition of Example is used, it has been found that the object to be polished can be polished at a high polishing removal rate, the number of dent defects is small, and even if a scratch occurs, the scratch is extremely shallow, the surface roughness of the surface of the object to be polished is small, and a smooth surface having a small waviness and a high surface quality can be obtained. In particular, it has been found that when the polishing compositions of Examples 1 and 2 are used, a higher polishing removal rate can be obtained. In addition, it has been also found that when the polishing compositions of Examples 4 and 5 are used, the surface quality of the surface of the object to be polished is further improved.

It has been found that when the polishing compositions of Comparative Examples 1 to 4 are used, the number of dent defects particularly increases and the surface quality of the surface of the object to be polished deteriorates.

Incidentally, this application is based on Japanese Patent Application No. 2018-061561 filed on March 28, 2018, the contents of which are entirely incorporated herein by reference.

## Claims

1. A polishing composition used for polishing an object to be polished, containing an alumina abrasive and a dispersion medium,
wherein the alumina abrasive contain only an α-alumina A having an α conversion rate of 80% or more and an α-alumina B having an α conversion rate of less than 80% as crystalline alumina, and an average particle size of the α-alumina A is smaller than an average particle size of the α-alumina B.

2. The polishing composition according to claim 1, wherein a content mass ratio of the α-alumina A and the α-alumina B is 5/95 or more and 95/5 or less.

3. The polishing composition according to claim 1 or 2, further comprising an oxidizing agent.

4. The polishing composition according to any one of claims 1 to 3, wherein a pH is 7 or more.

5. The polishing composition according to any one of claims 1 to 4, wherein the object to be polished contains a hard and brittle material.

6. The polishing composition according to claim 5, wherein the hard and brittle material comprises silicon carbide.

7. A method of producing a polishing composition, comprising mixing an α-alumina A having an α conversion rate of 80% or more and an α-alumina B having an α conversion rate of less than 80% in a dispersion medium,
wherein an average particle size of the α-alumina A is smaller than an average particle size of the α-alumina B.
